# DEMANDE DE BREVET EUROPEEN

(11) **EP 4 618 707 A1**
(43) Date de publication de la demande: **17.09.2025**
(21) Numéro de dépôt: 25163672.6
(22) Date de dépôt: 13.03.2025
(51) Int. Cl.: H05K 7/20

(54) **DISPOSITIF DE REFROIDISSEMENT POUR UN MODULE DE PUISSANCE**

(30) Priorité: 14.03.2024 FR 2402542
(71) Demandeur: Valeo eAutomotive Germany GmbH, 91056 Erlangen (DE)
(72) Inventeur: CHINNATHAMBI, Gowardanan, 94046 Créteil Cedex (FR); GUERIN, Fabien, 94046 Créteil Cedex (FR); GONCALVES-DA-COSTA, Ricardo, 94046 Créteil Cedex (FR); GILLION, Jean Noel, 94046 Créteil Cedex (FR)
(74) Mandataire: Valeo Powertrain Systems

(57) **Abrégé**

L'invention concerne un dispositif de refroidissement (10) pour un module de puissance (20) dans lequel:
- une partie de circulation comporte un empilement (13) de plaques de métal (14) comprenant une première plaque (141) et une pluralité de plaques intermédiaires (142) comportant des évidements (15) ménageant des canaux (15A),
- une partie de fixation comporte un couvercle (17) pour maintenir le module de puissance, adapté à plaquer le module de puissance contre la première plaque de l'empilement, et au moins un organe de fixation (18), le couvercle étant muni d'un orifice de passage dudit organe de fixation, cet orifice de passage étant adapté à être positionné en regard d'une ouverture d'accueil (30, 40) de la partie de circulation,
la plaque de fermeture comportant un renfoncement (31) ménagé en vis-à-vis de ladite ouverture d'accueil, de manière à créer un logement (31A) dans lequel débouche ladite ouverture d'accueil.

## Description

### Domaine technique

L'invention concerne un dispositif de refroidissement d'un module de puissance.

### Arrière-plan technologique

On connait de l'état de la technique des systèmes électriques et notamment des onduleurs comportant des modules de puissance. Ces modules de puissance sont de préférence associés à un dispositif de refroidissement destiné à empêcher l'échauffement de chaque module de puissance afin de garantir un fonctionnement optimal de celui-ci. Le dispositif de refroidissement comporte typiquement une partie de circulation d'un fluide de refroidissement contre laquelle le module de puissance est appliqué.

Le dispositif de refroidissement comprend un couvercle qui maintient le module de puissance contre la partie de circulation du dispositif de refroidissement, le couvercle étant lui-même fixé par exemple par vissage sur la partie de circulation du dispositif de refroidissement.

Le couvercle et la partie de circulation du dispositif de refroidissement comportent à cet effet un orifice de passage d'une vis de fixation.

Un inconvénient de cet agencement est que des poussières ou des particules sont générées par l'étape de fixation du couvercle sur la partie de circulation du dispositif de refroidissement, par exemple par vissage. Ces poussières ou particules peuvent s'échapper du dispositif de refroidissement et contaminer son environnement.

### Résumé de l'invention

Une idée à la base de l'invention est de fournir un dispositif de refroidissement limitant la quantité de poussières ou de particules s'échappant lorsque le couvercle retenant les modules de puissance est fixé sur lui, tout en étant simple, rapide et économique à produire.

Selon un mode de réalisation, l'invention fournit un dispositif de refroidissement pour un module de puissance comportant une partie de circulation dans laquelle un fluide de refroidissement est destiné à circuler et une partie de fixation pour fixer le module de puissance sur la partie de circulation, dans lequel:
- la partie de circulation comporte un empilement de plaques de métal comprenant une première plaque adaptée à recevoir le module de puissance et une pluralité de plaques intermédiaires comportant des évidements ménageant des canaux destinés à la circulation du fluide de refroidissement,
- la partie de fixation comporte un couvercle pour maintenir le module de puissance, adapté à plaquer le module de puissance contre la première plaque de l'empilement, et au moins un organe de fixation, le couvercle étant muni d'un orifice de passage dudit organe de fixation, cet orifice de passage étant adapté à être positionné en regard d'une ouverture d'accueil de la partie de circulation, pour la fixation de la partie de fixation sur la partie de circulation au moyen dudit organe de fixation,
ladite ouverture d'accueil de la partie de circulation étant percée à travers une pluralité de plaques de métal dudit empilement et fermée par une plaque de fermeture de l'empilement, la plaque de fermeture comportant un renfoncement ménagé en vis-à-vis de ladite ouverture d'accueil, de manière à créer un logement dans lequel débouche ladite ouverture d'accueil.

Grâce à ces caractéristiques, la fabrication du dispositif de refroidissement est rapide et ne produit pas de poussières. En effet, les poussières produites par le vissage de la vis de fixation dans l'ouverture d'accueil sont recueillies dans le renfoncement de la plaque de fermeture et non rejetées à l'extérieur du dispositif de refroidissement. En outre, cela est obtenu sans ajout de pièce supplémentaire en plus des plaques de métal de l'empilement.

Selon un mode de réalisation, ladite plaque de fermeture comporte une partie qui entoure ledit renfoncement et est plaquée contre l'une des plaques de l'empilement tout autour de l'ouverture d'accueil. Le renfoncement est ainsi localisé précisément autour de l'ouverture d'accueil.

Selon un mode de réalisation, ledit renfoncement est formé par emboutissage de la plaque de fermeture.

Selon un mode de réalisation, ledit renfoncement est formé par moulage de la plaque de fermeture.

Selon un mode de réalisation, chacune des plaques de l'empilement est réalisée en aluminium. Ce métal présente en effet une conductivité thermique élevée, de l'ordre de 110 W/m.K à 200 W/m.K.

Selon un mode de réalisation, l'organe de fixation est une vis filetée et l'ouverture d'accueil comporte un filetage destiné à coopérer avec la vis filetée.

Selon un mode de réalisation, l'organe de fixation est une vis auto-filetante et l'ouverture d'accueil est non filetée avant insertion de la vis.

Selon un mode de réalisation, le couvercle de la partie de fixation est moulé.

Selon un mode de réalisation, le couvercle de la partie de fixation comprend une plaquette d'appui destinée à plaquer le module de puissance contre la première plaque de l'empilement et au moins un bras à l'extrémité duquel est ménagé l'orifice de passage de l'organe de fixation.

L'invention concerne en outre un ensemble de puissance, comportant un module de puissance et un dispositif de refroidissement tel que décrit précédemment, le module de puissance étant disposé entre la partie de circulation et la partie de fixation du dispositif de refroidissement, plaqué contre la première plaque de l'empilement par la partie de fixation.

L'invention concerne enfin un procédé de fabrication d'une partie d'un dispositif de refroidissement tel que décrit précédemment, selon lequel :
- on assemble une pluralité de plaques de métal dudit empilement,
- on perce l'ouverture d'accueil à travers la pluralité de plaques de métal dudit empilement,
- on assemble une plaque de fermeture à ladite pluralité de plaques de l'empilement, de telle sorte que le renfoncement de la plaque de fermeture soit disposé en vis-à-vis de ladite ouverture d'accueil.

### Brève description des figures

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.
La figure 1 représente schématiquement une vue en coupe selon le plan A-A de la figure 3 d'un ensemble de puissance comprenant trois modules de puissance et un dispositif de refroidissement.
La figure 2 représente schématiquement une vue agrandie d'un détail de la figure 1.
La figure 3 est une représentation schématique en perspective de dessus de l'ensemble de la figure 1.
La figure 4 est une représentation schématique en perspective de dessus de l'ensemble de la figure 3, selon une direction d'observation opposée à celle de la figure 3.
La figure 5 est une représentation schématique en perspective vue de dessous de l'ensemble de la figure 1.

### Description des modes de réalisation

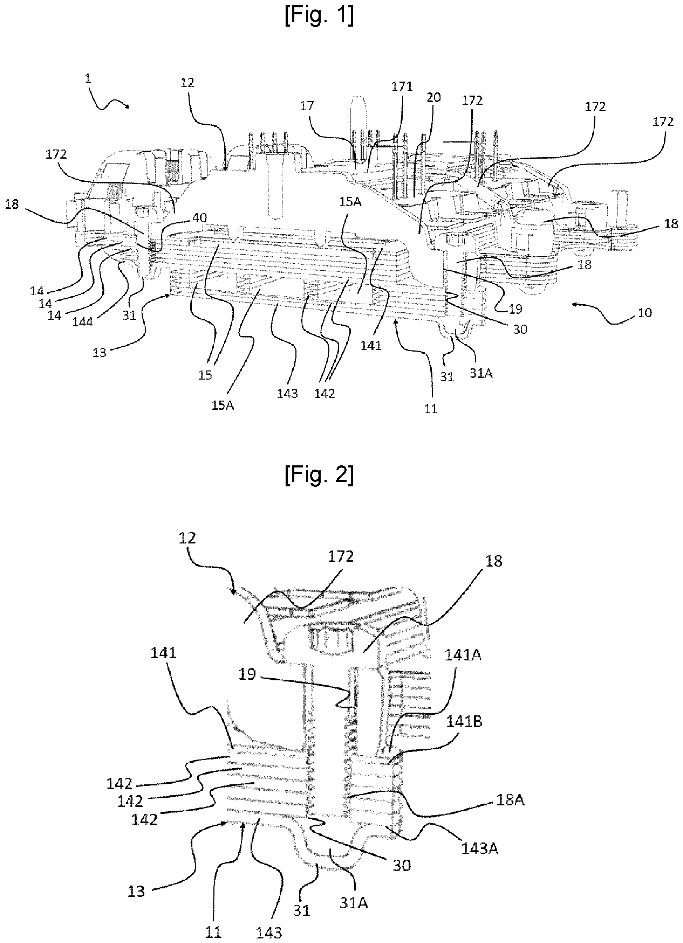

On a représenté sur les figures 1, 3, 4 et 5 un ensemble de puissance 1. Celui-ci comprend un dispositif de refroidissement 10 et trois modules de puissance 20. Les modules de puissance 20 sont typiquement des composants agencés pour la conversion d'énergie électrique de courant continu en courant alternatif ou vice versa. Ils sont ainsi destinés à former un onduleur, notamment pour un véhicule électrique, c'est-à dire un dispositif agencé pour convertir le courant continu délivré par une batterie électrique en un en courant alternatif pour alimenter une machine électrique à courant alternatif et vice-versa.

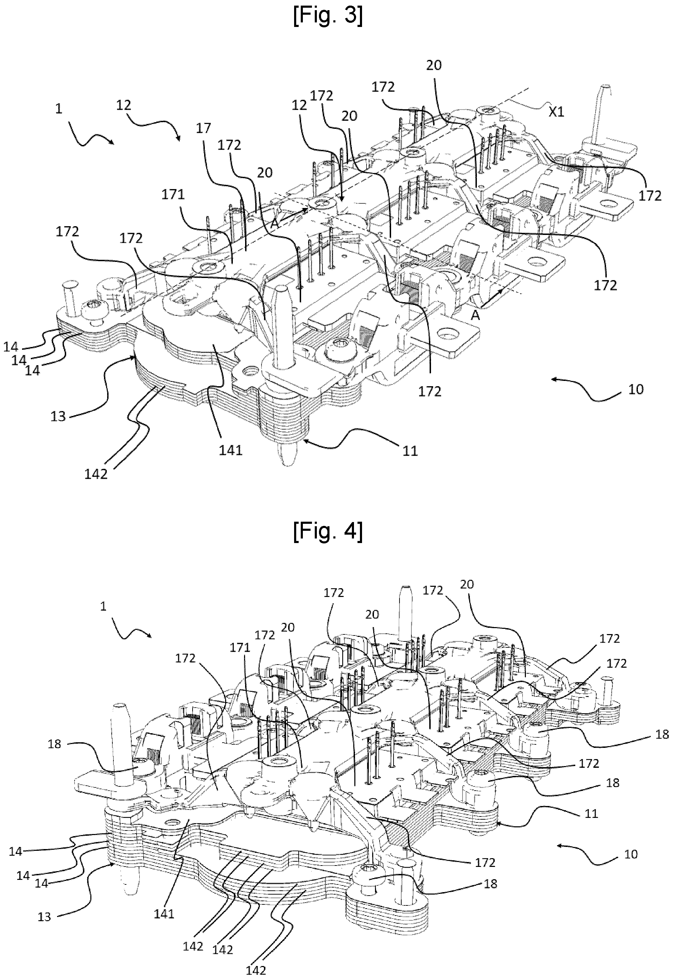

Chaque module de puissance 20 se présente sous la forme d'un bloc de forme globalement parallélépipédique aplatie. Les trois modules de puissance 20 sont ici disposés côte à côte, alignés le long d'une direction longitudinale X1 du dispositif de refroidissement 10 (figure 3).

Le dispositif de refroidissement présente ici une forme allongée selon cette direction longitudinale X1.

Le dispositif de refroidissement 10 comporte une partie de circulation 11 dans laquelle un fluide de refroidissement est destiné à circuler et une partie de fixation 12 pour fixer le module de puissance 20 sur la partie de circulation 11.

La partie de circulation 11 comporte un empilement 13 de plaques de métal 14 comprenant une première plaque 141 adaptée à recevoir le module de puissance 20 et une pluralité de plaques intermédiaires 142 comportant des évidements 15 ménageant des canaux destinés à la circulation du fluide de refroidissement (figure 1).

Le fluide de refroidissement est un liquide, par exemple à base d'eau avec des additifs par exemple à base de glycol ou tout autre liquide de refroidissement utilisé dans l'automobile.

Chacune des plaques de l'empilement est réalisée en aluminium. Ce matériau assure des échanges thermiques efficaces avec le fluide de refroidissement.

L'empilement 13 de plaques de métal 14 de la partie de circulation 11 comporte en outre une dernière plaque 143 disposée à l'opposé de la première plaque 141 dans l'empilement.

La première plaque 141 et les plaques intermédiaires 142 sont planes et comportent deux faces principales parallèles reliées par une tranche périphérique.

Une face avant 141A de la première plaque 141 reçoit chaque module de puissance 20. Une face arrière 141B de la première plaque 141 opposée à sa face avant 141A est appliquée contre les plaques de métal intermédiaires 142.

Les faces principales des plaques de métal intermédiaires 142 sont accolées les unes contre les autres.

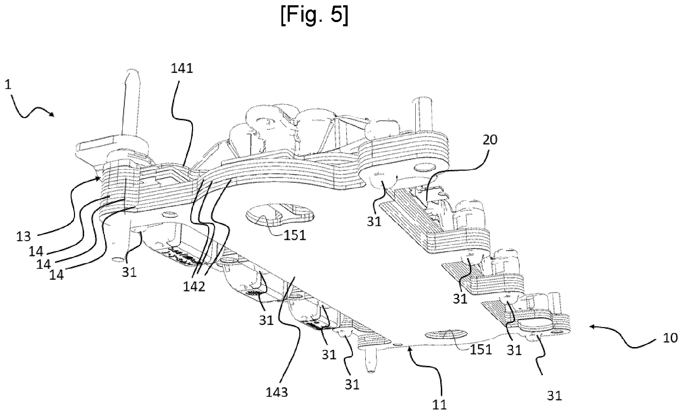

Les évidements 15 de chaque couple de deux plaques intermédiaires 142 voisines juxtaposées dans l'empilement 13 sont en communication au moins partielle. Des canaux 15A sont ainsi ménagés dans l'empilement de plaques de métal 14 par la mise en communication de ces évidements 15 (figure 1). Ces canaux débouchent à l'extérieur de la partie de circulation 11, de manière à pouvoir être reliés à un système de circulation de fluide de refroidissement (figure 5). Le système de circulation de fluide de refroidissement injecte dans les canaux ainsi formés un fluide de refroidissement qui circule dans les canaux pour dissiper une partie de la chaleur contenue dans la partie de circulation et ainsi refroidir celle-ci.

La dernière plaque 143 présente également une face avant 143A dont au moins une partie est plane et contre laquelle est positionnée la face arrière de la plaque intermédiaire 142 de l'empilement 13 adjacente à la dernière plaque 143.

La dernière plaque 143 ferme au moins partiellement les canaux 15A. Elle peut comporter des ouvertures 151 (figure 5) permettant de relier les canaux 15A au système de circulation de fluide (non représenté).

La partie de fixation 12 comporte un couvercle 17 pour maintenir chaque module de puissance 20. Le couvercle 17 est adapté à plaquer chaque module de puissance 20 contre la première plaque 141 de l'empilement 13.

La partie de fixation 12 comporte en outre au moins un organe de fixation 18 (figure 3).

Le couvercle 17 est muni d'au moins un orifice de passage 19 dudit organe de fixation 18.

Le couvercle 17 de la partie de fixation 12 est par exemple moulé en métal, tel qu'en aluminium.

Plus précisément, il est prévu ici huit organes de fixation et huit orifices de passage correspondants.

Chaque orifice de passage 19 est adapté à être positionné en regard d'une ouverture d'accueil 30, 40 de la partie de circulation 11, pour la fixation de la partie de fixation 12 sur la partie de circulation 11 au moyen dudit organe de fixation 18.

En pratique, le couvercle 17 présente ici la forme d'un cavalier avec une plaquette centrale d'appui 171 et une pluralité de bras latéraux 172 qui s'étendent à partir de la plaquette centrale d'appui 171.

La plaquette centrale d'appui 171 s'étend le long de la direction longitudinale X1 du dispositif de refroidissement 10.

La plaquette centrale d'appui 171 est destinée à plaquer le module de puissance 20 contre la partie de circulation 11 du dispositif de refroidissement 10.

Lorsque le couvercle 17 est en place sur la partie de circulation 11, la plaquette centrale d'appui 171 s'étend à distance de la première plaque de métal 141, globalement parallèlement à sa face avant 141A. Un logement de réception de chaque module de puissance 20 est ainsi ménagé entre la face avant 141A de la première plaque 141 et la plaquette centrale d'appui 171 du couvercle 17.

L'écart entre la plaquette centrale d'appui 171 et la face avant 141A de la première plaque 141 de l'empilement 13 lorsque la partie de fixation 12 est fixée sur la partie de circulation 11 est déterminé pour que chaque module de puissance 20 soit plaqué contre la face avant 141A de la première plaque 141 lorsque la partie de fixation 12 est fixée sur la partie de circulation 11.

Chaque bras latéral 172 de la partie de fixation 170 s'étend à partir de la plaquette centrale 171 jusqu'à la face avant 141A de la première plaque de métal 141. La forme des bras latéraux 172 impose l'écart décrit précédemment entre la plaquette centrale d'appui 171 et la face avant 141A de la première plaque 141 de l'empilement 13 lorsque la partie de fixation 12 est fixée sur la partie de circulation 11.

Les bras latéraux 172 du couvercle 17 s'étendent de part et d'autre de la plaquette centrale d'appui 171. Une partie d'entre eux s'étend entre les modules de puissance 20 et de part et d'autre de ceux-ci. Les bras latéraux qui s'étendent entre les modules de puissance 20 s'étendent perpendiculairement à l'axe longitudinal X1. Le couvercle 17 peut comprendre également d'autres bras latéraux 172 qui s'étendent avec un angle non nul autre que 90° par rapport à la plaquette centrale 171. Il s'agit notamment des bras latéraux 172 qui s'étendent à chaque extrémité de la plaquette centrale 171 et bloquent les modules de puissance 20 aux extrémités longitudinales du dispositif.

Les bras latéraux 172 séparent deux à deux les modules de puissance le long de la direction longitudinale X1 et bloquent tout mouvement des modules de puissance le long de cette direction longitudinale X1.

Le couvercle comprend ici à cet effet huit bras latéraux 172 qui encadrent et séparent les trois modules de puissance 20.

Il est prévu un orifice de passage 19 de l'organe de fixation 18 à l'extrémité de chaque bras latéral 172.

L'ouverture d'accueil 30, 40 de la partie de circulation 11 correspondant à chaque orifice de passage 19 de la partie de fixation 12 est percée à travers une pluralité de plaques 141, 142 de métal dudit empilement 13 et fermée par une plaque de fermeture 143, 144 de l'empilement 13.

La plaque de fermeture 143, 144 peut être la dernière plaque 143 de l'empilement 13 ou l'une 144 des plaques intermédiaires 142.

La plaque de fermeture 143, 144 comporte un renfoncement 31 ménagé en vis-à-vis de ladite ouverture d'accueil 30, de manière à créer un logement 31A dans lequel débouche ladite ouverture d'accueil 30, 40 (figure 1). Ce renfoncement 31 correspond à un creux de la face avant 143A de la plaque de fermeture 143, 144 (figure 2).

Le logement 31A délimite un espace intérieur qui s'étend dans le prolongement de l'ouverture d'accueil 30, 40.

La plaque de fermeture 143, 144 comporte en outre une partie qui entoure ledit renfoncement 31 et est plaquée contre l'une des plaques de l'empilement tout autour de l'ouverture d'accueil (30). La partie qui s'étend autour du renfoncement forme par exemple une collerette plane qui est plaquée contre la face arrière de la plaque intermédiaire 142 adjacente à la plaque de fermeture. De préférence, le reste de la face avant 143A de la plaque de fermeture, hors renfoncement, est plan et appliqué contre la face arrière de la plaque intermédiaire adjacente à la plaque de fermeture.

Le renfoncement 31 est formé par exemple par emboutissage de la plaque de fermeture 143, 144.

En variante, le renfoncement est formé par moulage de la plaque de fermeture.

L'organe de fixation 18 est par exemple une vis filetée et l'ouverture d'accueil 30, 40 comporte un filetage 18A (figure 2) destiné à coopérer avec la vis filetée.

En variante, l'organe de fixation est une vis auto-filetante et l'ouverture d'accueil est non filetée avant insertion de la vis auto-filetante.

En variante encore, l'organe de fixation peut comprendre une partie d'encliquetage coopérant avec une ouverture ou un système de sertissage ou de rivetage.

Le dispositif de refroidissement 10 comporte ainsi, de manière intégrée à l'empilement de plaque de métal 14 formant la partie de circulation 11 du fluide de refroidissement, le logement 31A qui ferme l'ouverture d'accueil 30, 40 de la partie de circulation 11 dans laquelle est fixée l'organe de fixation.

Les poussières ou particules générées par l'introduction de l'organe de fixation 18 dans l'ouverture d'accueil 30, 40 ne peuvent pas s'échapper de la partie de circulation 11 du dispositif de refroidissement. Ces poussières ou particules sont retenues à l'intérieur du logement 31A. Ainsi, l'environnement du dispositif de refroidissement reste propre, exempt de poussières ou particules.

En outre, cela est réalisé de manière particulièrement simple, rapide et économique. En effet, aucun élément additionnel n'est utilisé pour retenir les poussières et particules. Le logement est formé par l'une des plaques de métal de l'empilement de plaques de métal 14 de la partie de circulation 11.

En particulier, selon un mode de réalisation une partie d'un dispositif de refroidissement est fabriqué selon les étapes suivantes :
- on assemble une pluralité de plaques de métal 14 dudit empilement 13, par exemple par brasure,
- on perce l'ouverture d'accueil 30, 40 à travers la pluralité de plaques de métal 14 dudit empilement 13,
- on assemble une plaque de fermeture 143, 144 comportant un renfoncement 31 à ladite pluralité de plaques de l'empilement 13, de telle sorte que le renfoncement 31 de la plaque de fermeture 143, 144 soit disposé en vis-à-vis de ladite ouverture d'accueil 30, 40.

Ainsi, chaque ouverture d'accueil est percée en une seule fois, à travers les plaques de métal déjà assemblées.

Le logement 31A est formé par l'assemblage des plaques de métal entre elles.

En outre, d'autres ouvertures traversant une pluralité de plaques de métal de l'empilement peuvent également être fermées par une plaque de fermeture comprenant un renfoncement de manière à former un logement prolongeant ces autres ouvertures.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

On a décrit ici un ensemble de puissance comprenant un dispositif de refroidissement et trois modules de puissance. L'ensemble de puissance peut également comprendre un dispositif de refroidissement et au moins un module de puissance. Il comprend de préférence un dispositif de refroidissement et entre un et un nombre N de modules de puissance, N étant un nombre entier. Par exemple N est égal à 3 ou 5 ou 6 ou 10. Chaque module de puissance peut être formé d'un module comprenant un ensemble de composants électroniques dont des transistors, par exemple des transistors MOS, formant des interrupteurs. Alternativement, un modulede puissance peut être composé d'un composant discret tel qu'un transistor IGBT. Alternativement encore, un module de puissance peut être remplacé par un module d'excitation, notamment un module d'excitation d'une bobine du rotor d'une machine électrique tournante.

L'usage du verbe « comporter », « comprendre » ou « inclure » et de ses formes conjuguées n'exclut pas la présence d'autres éléments ou d'autres étapes que ceux énoncés dans une revendication.

Dans les revendications, tout signe de référence entre parenthèses ne saurait être interprété comme une limitation de la revendication.

## Revendications

1. Dispositif de refroidissement (10) pour un module de puissance (20) comportant une partie de circulation (11) dans laquelle un fluide de refroidissement est destiné à circuler et une partie de fixation (12) pour fixer le module de puissance (20) sur la partie de circulation (11), dans lequel :
- la partie de circulation (11) comporte un empilement (13) de plaques de métal (14) comprenant une première plaque (141) adaptée à recevoir le module de puissance (20) et une pluralité de plaques intermédiaires (142) comportant des évidements (15) ménageant des canaux (15A) destinés à la circulation du fluide de refroidissement,
- la partie de fixation (12) comporte un couvercle (17) pour maintenir le module de puissance (20), adapté à plaquer le module de puissance (20) contre la première plaque (141) de l'empilement (13), et au moins un organe de fixation (18), le couvercle (17) étant muni d'un orifice de passage (19) dudit organe de fixation (18), cet orifice de passage (19) étant adapté à être positionné en regard d'une ouverture d'accueil (30, 40) de la partie de circulation (11), pour la fixation de la partie de fixation (12) sur la partie de circulation (11) au moyen dudit organe de fixation (18),
ladite ouverture d'accueil (30, 40) de la partie de circulation (11) étant percée à travers une pluralité de plaques (141, 142) de métal dudit empilement et fermée par une plaque de fermeture (143, 144) de l'empilement (13), la plaque de fermeture (143, 144) comportant un renfoncement (31) ménagé en vis-à-vis de ladite ouverture d'accueil (30), de manière à créer un logement (31A) dans lequel débouche ladite ouverture d'accueil (30, 40).

2. Dispositif de refroidissement (10) selon la revendication 1, dans lequel ladite plaque de fermeture (143, 144) comporte une partie qui entoure ledit renfoncement et est plaquée contre l'une des plaques de l'empilement 142) tout autour de l'ouverture d'accueil (30, 40).

3. Dispositif de refroidissement (10) selon l'une des revendications 1 et 2, dans lequel ledit renfoncement (31) est formé par emboutissage de la plaque de fermeture (143, 144).

4. Dispositif de refroidissement (10) selon l'une des revendications 1 à 3, dans lequel ledit renfoncement (31) est formé par moulage de la plaque de fermeture (143, 144).

5. Dispositif de refroidissement (10) selon l'une des revendications 1 à 4, dans lequel chacune des plaques de métal (14) de l'empilement (13) est réalisée en aluminium.

6. Dispositif de refroidissement (10) selon l'une des revendications 1 à 5, dans lequel l'organe de fixation (18) est une vis filetée et l'ouverture d'accueil (30, 40) comporte un filetage destiné à coopérer avec la vis filetée.

7. Dispositif de refroidissement (10) selon l'une des revendications 1 à 5, dans lequel l'organe de fixation (18) est une vis auto-filetante et l'ouverture d'accueil (30, 40) est non filetée avant insertion de la vis.

8. Dispositif de refroidissement (10) selon l'une des revendications 1 à 7, dans lequel le couvercle (17) de la partie de fixation (12) est moulé.

9. Dispositif de refroidissement (10) selon l'une des revendications 1 à 8, dans lequel le couvercle (17) de la partie de fixation (12) comprend une plaquette d'appui (171) destinée à plaquer le module de puissance (20) contre la première plaque (141) de l'empilement (13) et au moins un bras (172) à l'extrémité duquel est ménagé l'orifice de passage (19) de l'organe de fixation (18).

10. Ensemble de puissance (1), comportant un module de puissance (20) et un dispositif de refroidissement (10) selon l'une des revendications précédentes, le module de puissance (20) étant disposé entre la partie de circulation (11) et la partie de fixation (12) du dispositif de refroidissement (10), plaqué contre la première plaque (141) de l'empilement (13) par la partie de fixation (12).

11. Procédé de fabrication d'une partie d'un dispositif de refroidissement (10) selon la revendication 1, selon lequel :
- on assemble une pluralité de plaques de métal (14) dudit empilement (13),
- on perce l'ouverture d'accueil (30, 40) à travers la pluralité de plaques de métal (14) dudit empilement (13),
- on assemble une plaque de fermeture (143, 144) à ladite pluralité de plaques (14) de l'empilement (13), de telle sorte que le renfoncement (31) de la plaque de fermeture (143, 144) soit disposé en vis-à-vis de ladite ouverture d'accueil (30, 40).
